# EUROPÄISCHE PATENTSCHRIFT

(11) **EP 1 259 964 B1**
(45) Veröffentlichungstag und Bekanntmachung des Hinweises auf die Patenterteilung: **23.08.2006**
(21) Anmeldenummer: 01951355.5
(22) Anmeldetag: 01.06.2001
(51) Int. Cl.: G11C 16/04

(54) **NICHTFLÜCHTIGE NOR-ZWEITRANSISTOR-HALBLEITERSPEICHERZELLE SOWIE DAZUGEHÖRIGE NOR-HALBLEITERSPEICHEREINRICHTUNG UND VERFAHREN ZU DEREN HERSTELLUNG**
NON-VOLATILE NOR TWO-TRANSISTOR SEMICONDUCTOR MEMORY CELL, A CORRESPONDING NOR SEMICONDUCTOR MEMORY DEVICE AND A METHOD FOR THE PRODUCTION THEREOF
CELLULE DE MEMOIRE A SEMI-CONDUCTEUR NON-OU NON VOLATILE A DEUX TRANSISTORS, DISPOSITIF DE MEMOIRE A SEMI-CONDUCTEUR NON-OU CORRESPONDANT ET LEUR PROCEDE DE PRODUCTION

(30) Priorität: 06.06.2000 DE 10028422
(43) Veröffentlichungstag der Anmeldung: 27.11.2002
(73) Patentinhaber: Infineon Technologies AG, 81669 München (DE)
(72) Erfinder: GEORGAKOS, Georg, 85447 Fraunberg (DE); SZCZYPINSKI, Kazimierz, 81669 München (DE)
(74) Vertreter: Kindermann, Peter
(86) Internationale Anmeldenummer: PCT/DE2001/002069
(87) Internationale Veröffentlichungsnummer: WO 2001/095337

(56) Entgegenhaltungen:
- WO-A-99/19880
- US-A- 5 867 429

## Beschreibung

Die vorliegende Erfindung bezieht sich auf eine nichtflüchtige NOR-Halbleiterspeichereinrichtung mit zwei Eintransistor-Halbleiterspeicherzellen sowie ein zugehöriges Herstellungsverfahren und eine zugehörige NOR-Halbleiterspeichervorrichtung und insbesondere auf einen Flash EPROM-Speicher mit einer "Common-Source"-Architektur oder SNOR-Architektur, bei der jeweilige Source- und Drainleitungen selektiv angesteuert werden können.

Zum Speichern von grösseren Datenmengen werden derzeit von Rechnereinheiten bzw. Computern in der Regel magnetische Plattenlaufwerke benutzt. Derartige Plattenlaufwerke benötigen jedoch einen relativ großen Platz und weisen eine Vielzahl von beweglichen Teilen auf. Folglich sind sie störanfällig und besitzen einen beträchtlichen Stromverbrauch. Darüber hinaus werden die zukünftigen Rechnereinheiten bzw. Computer sowie andere digitale Geräte wie beispielsweise digitale Kameras, Musikwiedergabegeräte oder Palmgeräte bzw. PDAs immer kleiner, weshalb herkömmliche mechanische Speichervorrichtungen ungeeignet sind.

Als Alternative zu derartigen herkömmlichen mechanischen Speichervorrichtungen haben sich in letzter Zeit nichtflüchtige Halbleiterspeichervorrichtungen immer mehr durchgesetzt, wie sie beispielsweise als Flash-Speicher, E²PROM, EPROM und dergleichen bekannt sind. Als wichtigste Vertreter derartiger elektrisch löschbarer und elektrisch programmierbarer Speichervorrichtungen sind die sogenannten NAND- sowie NOR-Halbleiterspeichervorrichtungen bekannt. Beide Halbleiterspeichervorrichtungen weisen Halbleitereinrichtungen mit jeweils einer Eintransistor-Halbleiterspeicherzelle auf, wobei üblicherweise in einem aktiven Gebiet eines Halbleitersubstrats ein Draingebiet und ein Sourcegebiet ausgebildet ist und sich über dem dazwischen liegenden Kanalabschnitt eine isolierte ladungsspeichernde Schicht, wie z.B. ein floating gate, sowie eine darüber angeordnete isolierte Steuerschicht befindet. Zum Programmieren einer derartigen Eintransistor-Halbleiterspeicherzelle werden an die Steuerschicht und an das Draingebiet relativ hohe Spannungen angelegt. Unter derartigen Umständen erfolgt ein Einbringen von Ladungsträgern in die ladungsspeichernde Schicht mittels Kanalinjektion, Injektion heißer Ladungsträger und/oder Fowler-Nordheim-Tunneln. Die Ladungsträger verbleiben hierbei in der ladungsspeichernden Schicht und ändern nachhaltig das Schaltverhalten des jeweiligen Feldeffekttransistors.

Während in NAND-Halbleiterspeichereinrichtungen ein Vielzahl von Eintransistor-Halbleiterspeicherzellen seriell miteinander verbunden sind und über ein gemeinsames Auswahlgatter bzw. einen Auswahltransistor angesteuert werden, sind die jeweiligen Eintransistor-Halbleiterspeicherzellen in NOR-Halbleiterspeichereinrichtungen parallel bzw. matrixförmig organisiert, wodurch jede Speicherzelle einzeln angewählt werden kann.

Die vorliegende Erfindung bezieht sich ausschließlich auf derartige NOR-Halbleiterspeichereinrichtungen, bzw. zugehörige NOR-Halbleiterspeichervorrichtungen;

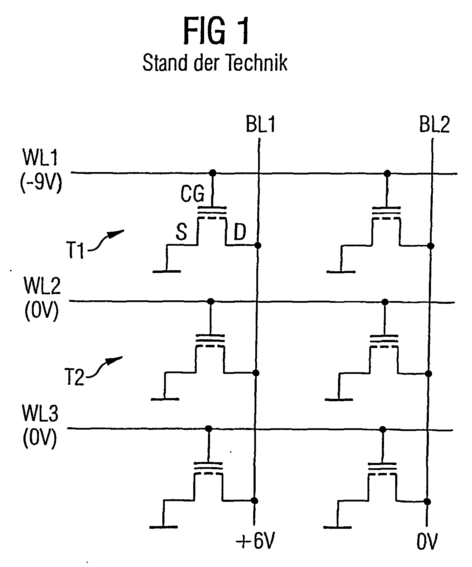

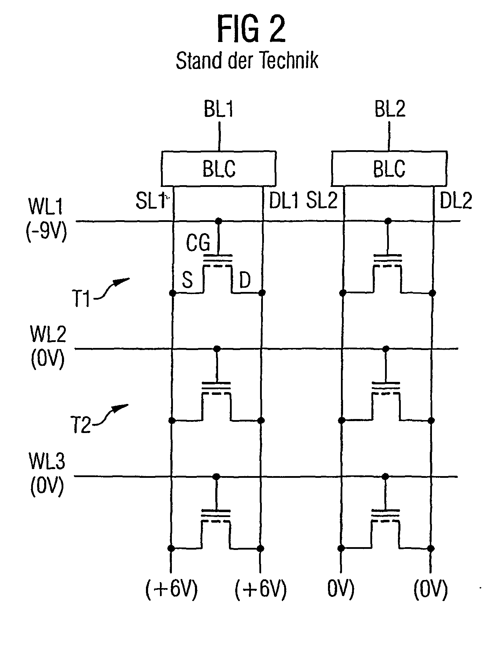

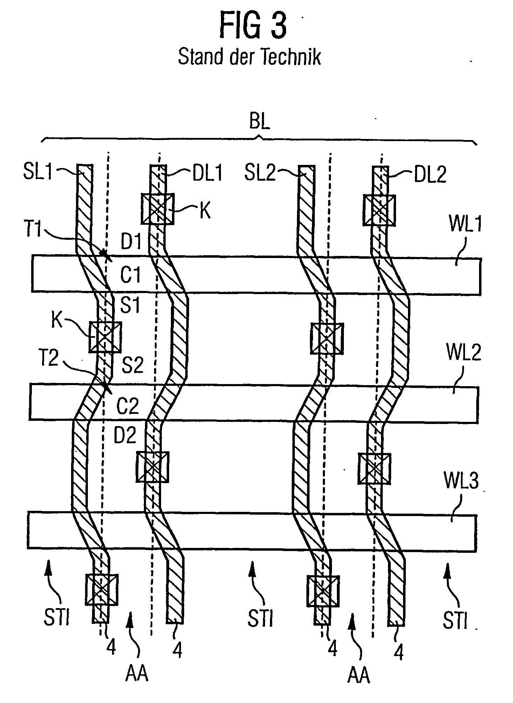

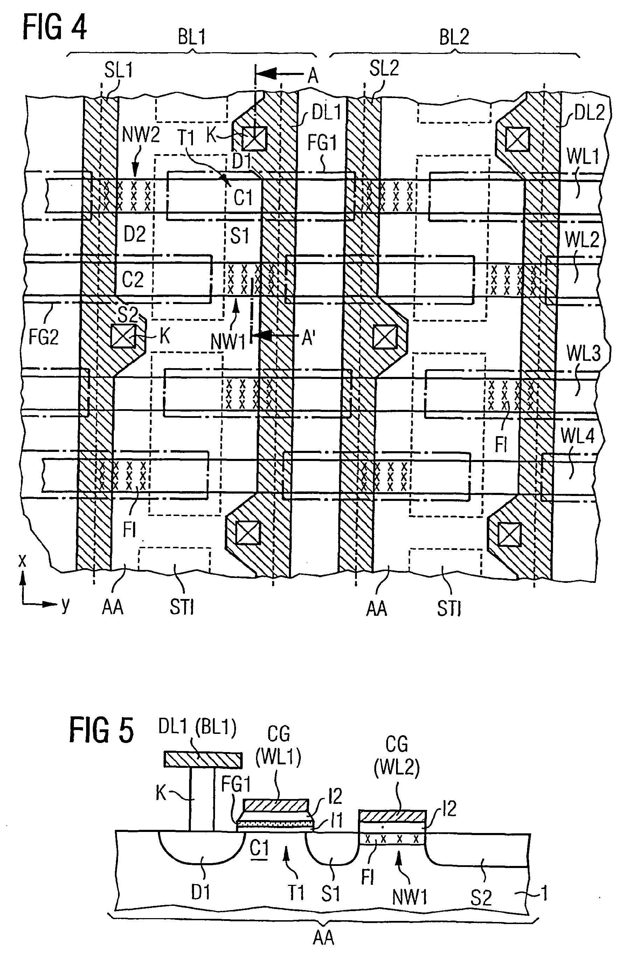

Figur 1 zeigt eine vereinfachte Darstellung eines Ersatzschaltbildes einer nichtflüchtigen NOR-Halbleiterspeichervorrichtung mit sog. "common-Source"-Architektur gemäß dem Stand der Technik. Gemäß Figur 1 sind eine Vielzahl von NOR-Halbleiterspeichereinrichtungen mit jeweils einer Eintransistor-Speicherzelle T1, T2, ... matrixförmig, d.h. zeilen- und spaltenweise angeordnet. Wie bereits vorstehend beschrieben wurde, besteht jede Eintransistor-Halbleiterspeicherzelle T1, T2, ... aus voneinander beabstandeten Drain- und Sourcegebieten D und S, die in einem aktiven Gebiet eines Halbleitersubstrats ausgebildet sind. Eine Steuerschicht CG (control gate) ist hierbei jeweils zeilenweise mit einer dazugehörigen Wortleitung WL1, WL2, WL3, ... verbunden. Demgegenüber sind die Draingebiete D der jeweiligen EintransistorHalbleiterspeicherzellen T1, T2, ... mit einer jeweiligen Bitleitung BL1, BL2, ... spaltenweise verbunden. Die Sourcegebiete S der nichtflüchtigen NOR-Halbleiterspeichervorrichtung liegen alle auf Masse bzw. sind alle miteinander verbunden, weshalb man eine derartige NOR-Halbleiterspeichervorrichtung als Speichervorrichtung mit "common source"-Architektur bezeichnet.

Nachteilig bei einer derartigen herkömmlichen Halbleiterspeichervorrichtung ist jedoch neben der relativ hohen Stromaufnahme während eines Programmiervorgangs eine begrenzte Integrationsmöglichkeit. Genauer gesagt führt bei einer weiter gehenden Integration bzw. Verkleinerung der Zellstrukturen die Verkürzung der Zelltransistoren bzw. der Kanalgebiete dazu, dass der Zelltransistor die Programmierspannung, die an der Bitleitung BL1, BL2 angelegt wird, nicht mehr sperren kann, wodurch ein Kurzschluss zur Source bzw. zur Masse hergestellt wird.

Zur Vermeidung von derartigen Kurzschlüssen bzw. unerwünschten Leckströmen wurden sogenannte SNOR-Halbleiterspeichervorrichtungen (selective NOR) verwendet, wobei eine selektive Ansteuerung der jeweiligen Source- und Draingebiete der Eintransistor-Halbleiterspeicherzellen ermöglicht wird und somit der beim Programmiervorgang entstehende hohe Spannungsabfall gezielt verringert werden kann.

Figur 2 zeigt eine vereinfachte Darstellung einer derartigen nicht flüchtigen SNOR-Halbleiterspeichervorrichtung, wobei gleiche Bezugszeichen gleiche oder ähnliche Elemente bezeichnen wie in Figur 1 und auf ihre wiederholte Beschreibung nachfolgend verzichtet wird.

Im Gegensatz zur vorstehend beschriebenen NOR-Halbieiterspeichervorrichtung mit "common source"-Architektur können die Halbleiterspeichereinrichtungen mit einer Eintransistor-Halbleiterspeicherzelle T1, T2, ... gemäß Figur 2 selektiv über eine jeweilige Sourceleitung SL1, SL2, ... und über eine jeweilige Drainleitung DL1, DL2, ... angesteuert werden. Diese selektive Ansteuerung wird beispielsweise über jeweilige Bitleitungssteuerungen BLC durchgeführt, welche sozusagen die gemeinsamen Bitleitungen BL1, BL2, ... realisieren. Auf diese Weise können weitere "shrinks" bzw. eine weitergehende Integration der Halbleiterspeichereinrichtung durchgeführt werden, da die SNOR-Architektur nicht auf eine vorbestimmte Mindest-Zelltransistorlänge bzw. Kanallänge angewiesen ist.

Figur 3 zeigt eine vereinfachte Darstellung eines Layouts der SNOR-Halbleiterspeichervorrichtung gemäß Figur 2. Gemäß Figur 3 werden die Halbleiterspeichereinrichtungen mit jeweils einer einzigen Eintransistor-Speicherzelle T1, T2, ... in aktiven Gebieten AA eines Halbleitersubstrats ausgebildet, die eine im Wesentlichen streifenförmige Struktur besitzen. Die Vielzahl von spaltenweise angeordneten streifenförmigen aktiven Gebieten AA werden zeilenweise von ebenfalls streifenförmig ausgebildeten Schichtstapeln überlagert, wobei eine oberste Schicht die Steuerschicht bzw. Wortleitung WL1, WL2, WL3, ... der Halbleiterspeichereinrichtung mit Eintransistor-Halbleiterspeicherzelle T1, T2, ... darstellt. Jeder Kreuzungspunkt bzw. Überlappungsbereich eines derartigen streifenförmigen aktiven Gebiets AA mit einer streifenförmig ausgebildeten Wortleitung WL1, WL2, WL3, ... stellt somit gemeinsam mit einer darunter liegenden ladungsspeichernden Schicht einen Feldeffekttransistor bzw. eine Halbeiterspeichereinrichtung mit Eintransistor-Speicherzelle dar. Zum Kontaktieren von jeweiligen Draingebieten D und Sourcegebieten S sind Kontakte K ausgebildet, die im Wesentlichen auf dem aktiven Bereich AA ausgebildet sind, jedoch auch in ein angrenzendes Isolationsgebiet STI (shallow trench isolation) reichen können. In einer weiteren darüber liegenden Schicht, die vorzugsweise eine erste Metallisierungsschicht darstellt, befinden sich nunmehr die Sourceleitungen SL1, SL2, ... sowie die Drainleitungen DL1, DL2, ... Die Drainleitungen DL1, DL2 stehen hierbei über entsprechende Kontakte K mit den dazugehörigen Draingebieten D des aktiven Bereichs in Verbindung, wobei in gleicher Weise die Sourceleitungen SL1, SL2 über entsprechende Kontakte K mit den dazugehörigen Sourcegebieten S in Verbindung stehen.

Nachteilig ist jedoch bei diesem Layout, dass auf Grund der zusätzlichen Sourceleitungen SL1, SL2, ... eine mehr als doppelt so intensive Metallisierung gegenüber einem Layout der "common-Source"-NOR-Architektur vorliegt, was wiederum einen begrenzenden Faktor für eine weitergehende Integration bzw. weitere "shrinks" darstellt.

Der Erfindung liegt daher die Aufgabe zu Grunde, eine nichtflüchtige NOR-Halbleiterspeichereinrichtung mit zwei Eintransistor-Halbleiterspeicherzellen eine zugehörige NOR-Halbleiterspeichervorrichtung sowie ein Verfahren zu deren Herstellung zu schaffen, wobei ein Platzbedarf insbesondere für eine Metallisierung und Kontaktierung verbessert ist und eine vereinfachte Integrationsmöglichkeit besteht.

Erfindungsgemäß wird diese Aufgabe hinsichtlich der nichtflüchtigen NOR-Halbleiterspeichereinrichtung mit zwei Eintransistor-Halbleiterspeicherzellen, durch die Merkmale des Patentanspruchs 1, hinsichtlich der NOR-Halbleiterspeicherervorrichtung durch die Merkmale des Patentanspruchs 3 und hinsichtlich des Verfahrens durch die Maßnahmen des Patentanspruchs 10 gelöst.

Insbesondere durch die Verwendung von im Wesentlichen ringförmig ausgebildeten aktiven Bereichen, wobei die beiden Speichertransistoren mit ihren Drain-, Kanal- und Sourcegebieten in sich gegenüberliegenden Segmenten des ringförmig ausgebildeten aktiven Bereiches ausgebildet sind, wobei die Draingebiete und die Sourcegebiete der beiden Speichertransistoren jeweils über den ringförmig ausgebildeten aktiven Bereich miteinander verbunden sind, kann die Anzahl der Kontakte halbiert werden, wodurch sich eine Metallisierung für die Source- und Drainleitungen deutlich entspannt. Die NOR-Halbleiterspeichereinrichtung mit zwei Eintransistor-Halbleiterspeicherzellen wird dadurch in Spaltenrichtung kompaktierbar, wodurch sich ferner ein Koppelfaktor, der sich aus einem Kapazitätsverhältnis von ladungsspeichernder Schicht/aktiver Bereich und ladungsspeichernder Schicht/Steuerschicht ergibt, verbessert. Darüber hinaus ergibt sich eine vollständige Kompatibilität mit den bereits bekannten SNOR- und Common-Source-Architekturen.

In den Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine vereinfachte Darstellung eines Ersatzschaltbildes einer nichtflüchtigen NOR-Halbleiterspeichervorrichtung mit "common-source"-Architektur gemäß dem Stand der Technik;
- Figur 2: eine vereinfachte Darstellung eines Ersatzschaltbildes einer nichtflüchtigen SNOR-Halbleiterspeichervorrichtung gemäß dem Stand der Technik;
- Figur 3: eine vereinfachte Darstellung eines Layouts der SNOR-Halbleiterspeichervorrichtung gemäß Figur 2;
- Figur4: eine vereinfachte Darstellung eines Layouts der erfindungsgemäßen NOR-Halbleiterspeichervorrichtung gemäß einem ersten Ausführungsbeispiel;
- Figur 5: eine vereinfachte Schnittansicht entlang eines Schnitts A/A' in Figur 4;
- Figur 6: einelvergrößerte und weiter vereinfachte Darstellung des Layouts einer erfindungsgemäßen NOR-Halbleiterspeichereinrichtung mit zwei Eintransistor-Halbleiterspeicherzellen gemäß Figur 4;
- Figur 7: eine vereinfachte Darstellung eines Ersatzschaltbildes der erfindungsgemäßen nichtflüchtigen NOR-Halbleiterspeichereinrichtung mit zwei Eintransistor-Halbleiterspeicherzellen;
- Figur 8: eine vereinfachte Darstellung eines Layouts der erfindungsgemäßen NOR-Halbleiterspeichervorrichtung gemäß einem zweiten Ausführungsbeispiel; und
- Figur 9: eine vereinfachte Schnittansicht entlang eines Schnitts B/B' in Figur 10;
- Figur 10: eine vereinfachte Darstellung einer bei der Herstellung der NOR-Halbleiterspeichervorrichtung gemäß dem ersten Ausführungsbeispiel verwendeten ersten Maskenschicht;
- Figur 11: eine vereinfachte Darstellung einer bei der Herstellung der NOR-Halbleiterspeichervorrichtung gemäß dem ersten Ausführungsbeispiel verwendeten weiteren Maskenschicht; und
- Figur 12: eine vereinfachte Darstellung eines Layouts der erfindungsgemäßen NOR-Halbleiterspeichervorrichtung gemäß einem dritten Ausführungsbeispiel.

Figur 4 zeigt eine vereinfachte Darstellung eines Layouts der erfindungsgemäßen NOR-Halbleiterspeichervorrichtung gemäß einem ersten Ausführungsbeispiel, wobei gleiche Bezugszeichen gleiche oder ähnliche Elemente wie in Figur 3 bezeichnen und daher auf eine wiederholte Beschreibung nachfolgend verzichtet wird.

Gemäß Figur 4 bestehen aktive Bereiche AA nunmehr aus im Wesentlichen ringförmig ausgebildeten Bereichen, die in jeweiligen Spalten untereinander aufgereiht sind. Eine Vielzahl von derartigen ringförmigen aktiven Bereichen, die zum Ausbilden einer jeweiligen nichtflüchtigen NOR-Halbleiterspeichereinrichtung mit zwei Eintransistor-Halbleiterspeicherzellen notwendig ist, ergeben somit eine leiterförmige Struktur. Vorzugsweise wird der ringförmige aktive Bereich AA durch Ausbilden von flachen Isolationsgräben STI (shallow trench isolation) in einem Halbleitersubstrat ausgebildet. Es kann jedoch auch jede weitere Isolation zum Ausbilden der aktiven Bereiche AA verwendet werden.

In jedem ringförmigen aktiven Bereich AA werden zum Ausbilden von zwei Eintransistor-Halbleiterspeicherzellen T1 und T2 jeweils ein Draingebiet D1 und D2, ein Sourcegebiet S1 und S2 und ein Kanalgebiet C1 und C2 ausgebildet. Vorzugsweise befinden sich die zwei Eintransistor-Halbleiterspeicherzellen T1 und T2 an punktsymmetrisch gegenüberliegenden Stellen des im Wesentlichen ringförmig ausgebildeten aktiven Bereichs AA.

Zum Ansteuern der ersten Eintransistor-Halbleiterspeicherzelle bzw. des ersten Speichertransistors T1 befindet sich eine erste Wortleitung WL1 im Wesentlichen über dem Kanalgebiet C1, wobei sie sich auch über daneben liegende ringförmige aktive Bereiche erstreckt, die wiederum spaltenförmig ausgebildet sind. In gleicher Weise erstreckt sich eine zweite Wortleitung WL2 zum Ansteuern der zweiten Eintransistor-Halbleiterspeicherzelle bzw. des zweiten Speichertransistors T2 über einem Kanalgebiet C2 sowie über Kanalgebieten von danebenliegenden aktiven Bereichen AA. Wortleitungen WL3 und WL4 steuern in ähnlicher Weise weitere Eintransistor-Halbleiterspeicherzellen bzw. Speichertransistoren in weiteren ringförmigen aktiven Bereichen AA an, wodurch sich eine gezielte Ansteuerung der matrixförmig angeordneten Eintransistor-Halbleiterspeicherzellen bzw. Speichertransistoren realisieren lässt. Die Wortleitungen WL1 bis WL4 bestehen vorzugsweise aus Polysilizium, können jedoch auch aus jeder weiteren elektrisch leitenden Schicht bestehen. Ferner befinden sich zur Realisierung des Speichereffektes unterhalb der Wortleitungen voneinander getrennte ladungsspeichernde Schichten FG1, FG2 usw.

Zum Kontaktieren der jeweiligen Source- und Draingebiete befinden sich gemäß Figur 4 vorzugsweise in jedem Eckbereich des ringförmig ausgebildeten aktiven Bereichs AA Kontakte K. Die Kontakte K werden hierbei in einer darüber liegenden Leiterebene bzw. Metallisierung über Sourceleitungen SL1, SL2, usw. sowie Drainleitungen DL1, DL2, ... angeschlossen, wodurch sich eine bitleitungsmäßige Ansteuerung der jeweiligen Eintransistor-Halbleiterspeicherzellen bzw. Speichertransistoren ergibt. Bei der in Figur 4 dargestellten SNOR-Halbleiterspeichervorrichtung stellt ein jeweiliges Source- und Drainleitungspaar SL1, DL1 und SL2, DL2 jeweils eine Bitleitung BL1 und BL2 dar.

Da die Wortleitungen WL1 bis WL4 auf Grund der ringförmigen Struktur der aktiven Bereiche AA diesen zweimal schneiden bzw. überlappen wird gemäß Figur 4 zur Vermeidung einer weiteren Feldeffektransistorstruktur bzw. eines weiteren Speichertransistors dieser weitere Schnittpunkt bzw. Überlappungsbereich derart ausgebildet, dass er keine ladungsspeichernde Schicht FG1 bzw. FG2 aufweist. Darüber hinaus wird der aktive Bereich AA unterhalb dieser Überlappungsbereiche derart behandelt, dass ein leitendes Gebiet FI (z.B. flaches Implantationsgebiet) ausgebildet wird. Vorzugsweise wird dieses leitende Gebiet durch eine Implantation von Ladungsträgern ausgebildet, wodurch sich ein nicht linearer Widerstand NW1 und NW2 realisieren lässt.

Auf diese Weise lässt sich einerseits die Struktur der Source- und Drainleitungen SL1, SL2 und DL1 und DL2 wesentlich vereinfachen, da sie nunmehr im Wesentlichen streifenförmig ausgebildet werden können. Dieses bedeutet eine wesentliche Vereinfachung der für die Source- und Drainleitung verwendeten Metallisierungsmasken. Darüber hinaus ermöglicht die ringförmige Struktur der aktiven Bereiche AA insbesondere gegenüber einer SNOR-Architektur eine wesentliche Verringerung der Anzahl von Kontakten K. Auf diese weise verringert sich insbesondere in x-Richtung ein benötigter Platzbedarf. Die Verringerung von Kontakten K ermöglicht jedoch auch eine weitere Verringerung eines Platzbedarfs in γ-Richtung, da unter Verwendung von Zickzack-, Mäander- oder überlappenden Strukturen die jeweiligen Source- und Drainleitungen zusammengeschoben werden können.

Ein wesentlicher Vorteil der ringförmigen aktiven Bereiche AA ergibt sich auch für einen Koppelfaktor, der im Wesentlichen ein Verhältnis aus der Kapazität zwischen Kanalgebiet (Halbleitersubstrat) und ladungsspeichernder Schicht FG sowie der Kapazität zwischen ladungsspeichernder Schicht FG und Steuerschicht darstellt. Der Kopplungsfaktor ist insbesondere für das Lesen bzw. Schreiben von Ladungen aus der Eintransistor-Halbleiterspeicherzelle von Bedeutung, da eine verbesserte Kopplung die benötigten Programmierspannungen wesentlich verringert und somit entsprechende (nicht dargestellte) Spannungs-Generatorschaltungen weiter vereinfacht und verkleinert werden können.

Gemäß Figur 4 wird folglich die Fläche der ladungsspeichernden Schicht FG1 und FG2 bei verkleinerter Zellfläche nicht verringert, sondern kann sogar vergrößert werden, wodurch sich ein verbesserter Kopplungsfaktor ergibt.

Figur 5 zeigt eine vereinfachte Schnittansicht entlang eines Schnitts A/A' gemäß Figur 4. Das Bezugszeichen 1 bezeichnet hierbei ein Halbleitersubstrat, welches vorzugsweise Silizium aufweist und einen Teil des ringförmig ausgebildeten aktiven Bereichs AA darstellt. Im aktiven Bereich AA bzw. Halbleitersubstrat 1 ist ein Draingebiet D1, ein Kanalgebiet C1, ein Sourcegebiet S1 und ein Sourcegebiet S2 ausgebildet. Das Draingebiet D1 steht hierbei über einen Kontakt K mit der Drainleitung DL1 in Verbindung, die sich in einer darüber liegenden elektrisch leitenden Schicht befindet. Vorzugsweise befindet sich die Drainleitung DL1 sowie eine nicht dargestellte Sourceleitung SL1 in einer ersten Metallisierungsschicht.

Zum Ausbilden des ersten Speichertransistors bzw. der ersten Eintransistor-Halbleiterspeicherzelle T1 befindet sich gemäß Figur 5 oberhalb des Kanalgebiets C1 eine erste Isolationsschicht I1, die vorzugsweise als Tunnel-Isolationsschicht ausgebildet ist und beispielsweise aus SiO₂ besteht. Auf der Tunnel-Isolationsschicht I1 befindet sich zum Speichern der mittels Kanalinjektion, Injektion heißer Ladungsträger und/oder Fowler-Nordheim-Tunneln eingebrachten Ladungen die ladungsspeichernde Schicht FG1 (floating gate), die jedoch auch aus einer Vielzahl von ladungsspeichernden Schichten bestehen kann. Zum Ansteuern der Eintransistor-Halbleiterspeicherzelle T1 befindet sich durch eine zweite Isolationsschicht I2 von der ladungsspeichernden Schicht FG1 isoliert eine Steuerschicht CG, die gemäß Figur 4 aus der Wortleitung WL1 ausgebildet wird. Da aufgrund der ringförmigen Struktur des aktiven Bereichs AA jede Wortleitung einen zweiten Überlappungsbereich mit dem aktiven Bereich AA aufweist, wird beispielsweise bei dem von der Infineon Technologies AG verwendeten C9-Prozess dieser zweite Überlappungsbereich durch eine Implantation zum Ausbilden eines flachen Implantationsgebiets bzw. leitenden Gebietes FI elektrisch leitend gemacht, wodurch der nicht lineare Widerstand NW1 ausgebildet wird. Die darüber liegende Steuerschicht CG der Wortleitung WL2 besitzt demzufolge keinen wesentlichen Einfluss auf den Stromfluss zwischen dem Sourcegebiet S1 und dem Sourcegebiet S2. Bei Verwendung von anderen Prozessen kann jedoch der nicht lineare Widerstand NW1 auch anders hergestellt werden, wobei lediglich die elektrisch leitende Verbindung zwischen den Sourcegebieten S1 und S2 von Bedeutung ist.

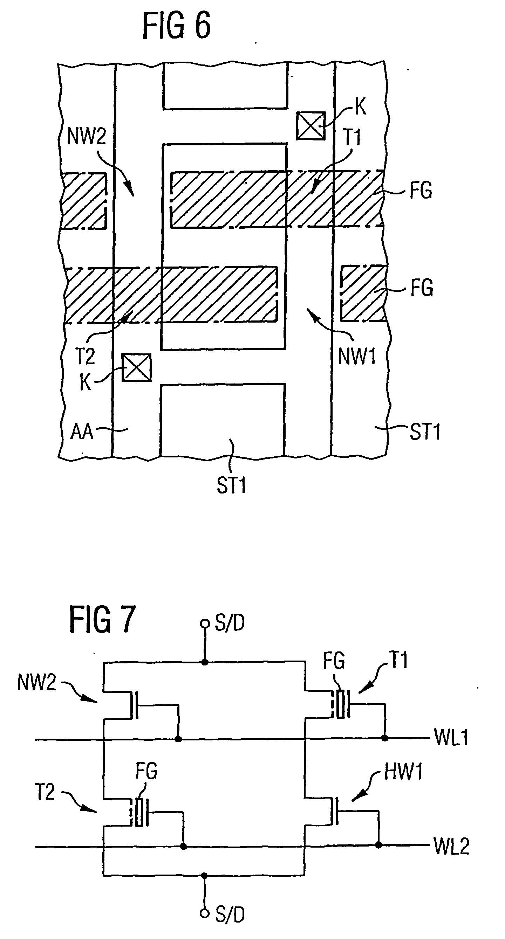

Figur 6 zeigt eine weiter vereinfachte Teildarstellung von Figur 4 zur Veranschaulichung einer erfindungsgemäßen NOR-Halbleiterspeichereinrichtung mit zwei Eintransistor-Halbleiterspeicherzellen. Zur klareren Darstellung wurde hierbei bewusst auf die Darstellung der Wortleitungen sowie Source- und Drainleitungen verzichtet.

Gemäß Figur 6 besteht die erfindungsgemäße Halbleiterspeichereinrichtung mit zwei Eintransistor-Halbleiterspeicherzellen aus einem ringförmig ausgebildeten aktiven Bereich AA, der vorzugsweise über flache Grabenisolierung STI im Halbleitersubstrat ausgebildet wird. Zum Herstellen von elektrischen Anschlüssen für die Drain- und Sourcegebiete befinden sich Kontakte K vorzugsweise in gegenüberliegenden Eckbereichen des aktiven Bereichs AA. Die Kontakte K können jedoch auch in der Mitte des oberen und unteren Querstegs oder an einer sonstigen Stelle des aktiven Bereichs AA angeordnet sein. Zur Vereinfachung der Herstellung der Halbleiterspeichereinrichtung mit zwei Eintransistor-Halbleiterspeicherzellen befinden sich die ladungsspeichernden Schichten FG vorzugsweise unmittelbar unterhalb der nicht dargestellten Wortleitungen, wodurch selbstjustierende Verfahren verwendet werden können. Die Eintransistor-Halbleiterspeicherzellen T1 und T2 werden hierbei jeweils an den Überlappungsbereichen mit dem aktiven Bereich AA ausgebildet, wobei die ohnehin notwendigen Unterbrechungen für die jeweiligen ladungsspeichernden Schichten FG unmittelbar an einem jeweils zweiten Überlappungsbereich ausgebildet werden. Auf diese Weise können die vorstehend beschriebenen elektrisch leitenden Gebiete FI im aktiven Bereich bzw. die nicht linearen Widerstände NW1 und NW2 ebenfalls selbstjustierend ausgebildet werden.

Figur 7 zeigt ein vereinfachte Darstellung eines Ersatzschaltbildes der nichtflüchtigen NOR-Halbleiterspeichereinrichtung mit zwei Eintransistor-Halbleiterspeicherzellen gemäß Figur 6, wobei gleiche Bezugszeichen gleiche oder ähnliche Elemente wie in Figuren 4 bis 6 bezeichnen. Demzufolge befinden sich bei der ringförmigen Struktur des aktiven Bereichs AA zwei Eintransistor-Halbleiterspeicherzellen T1 und T2 in jeweils gegenüber liegenden Bereichen und können über die Wortleitungen WL1 und WL2 sowie Source-/Drainanschlüsse S/D selektiv angesteuert werden. Die in der Ladungsspeicherschicht FG jeweils abgelegte Ladung bestimmt hierbei den Informationsgehalt der Eintransistor-Halbleiterspeicherzellen T1 und T2. Bei der Verwendung des Infineon-C9-Prozesses entstehen ferner die nicht linearen Widerstände NW1 und NW2, die jeweils eine leitende Verbindung von den Source-/Drainanschlüssen S/D zu den Eintransistor-Halbleiterspeicherzellen T1 und T2 realisieren. Bei der Verwendung von anderen Prozessen können jedoch beispielsweise durch Änderung einer Schichtdicke der zweiten Isolationsschicht 12 ein Einfluss der jeweiligen Wortleitung auf das darunter liegende Kanalgebiet der nicht linearen Widerstände derart verringert werden, dass sie spannungsunabhängige lineare Widerstände darstellen. In diesem Fall ist eine Feldeffekttransistorfunktion an den weiteren Überlappungsbereichen ausgeschlossen.

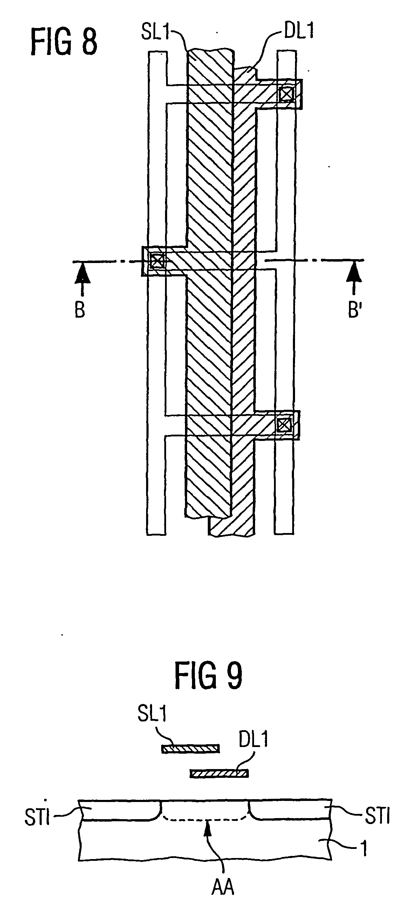

Figur 8 zeigt eine vereinfachte Darstellung eines Layouts der erfindungsgemäßen NOR-Halbleiterspeichervorrichtung gemäß einem zweiten Ausführungsbeispiel, wobei gleiche Bezugszeichen wiederum gleiche oder ähnliche Elemente wie in den Figuren 4 bis 7 bezeichnen. Zur Vereinfachung der Darstellung wurde hierbei auf die Wortleitungen WL1, ... sowie die ladungsspeichernden Schichten FG1, ... verzichtet und ledig-lich eine Spalte von NOR-Halbleiterspeichereinrichtung mit zwei Eintransistor-Halbleiterspeicherzellen dargestellt.

Gemäß Figur 8 können die in Figur 4 in der gleichen elektrisch leitenden Schicht ausgebildeten Source- und Drainleitungen auch in unterschiedlichen elektrisch leitenden Schichten ausgebildet sein, wodurch sich eine weitere Verdichtung bzw. Verringerung eines Platzbedarfs erreichen lässt. Die Source- und Drainleitungen SL1 und DL1 sind hierbei im Wesentlichen parallel zueinander angeordnet und weisen eine streifenförmige Struktur auf. Sie können jedoch auch mäander-, zickzack- oder wellenförmig ausgebildet sein, wobei sie parallel zueinander verlaufen oder sich teilweise überlappen.

Figur 9 zeigt eine vereinfachte Schnittansicht entlang eines Schnitts B/B' in Figur 8. Im Halbleitersubstrat 1 wird hierbei durch geeignete Isolierung STI ein aktiver Bereich AA ausgebildet. Die Drainleitung DL1 befindet sich nunmehr gemäß Figur 9 in einer ersten leitenden Schicht bzw. Metallisierungsschicht und die Sourceleitung SL1 in einer zweiten leitenden Schicht bzw. Metallisierungsschicht, wobei sich die Metallisierungsschichten teilweise überlappen können und durch eine nicht dargestellte Isolationsschicht voneinander beabstandet sind. Auf diese Weise erhält man eine weitere wesentliche Reduzierung der Zellfläche für die NOR-Halbleiterspeichereinrichtung mit zwei Eintransistor-Halbleiterspeicherzellen und damit für die gesamte NOR-Halbleiterspeichervorrichtung.

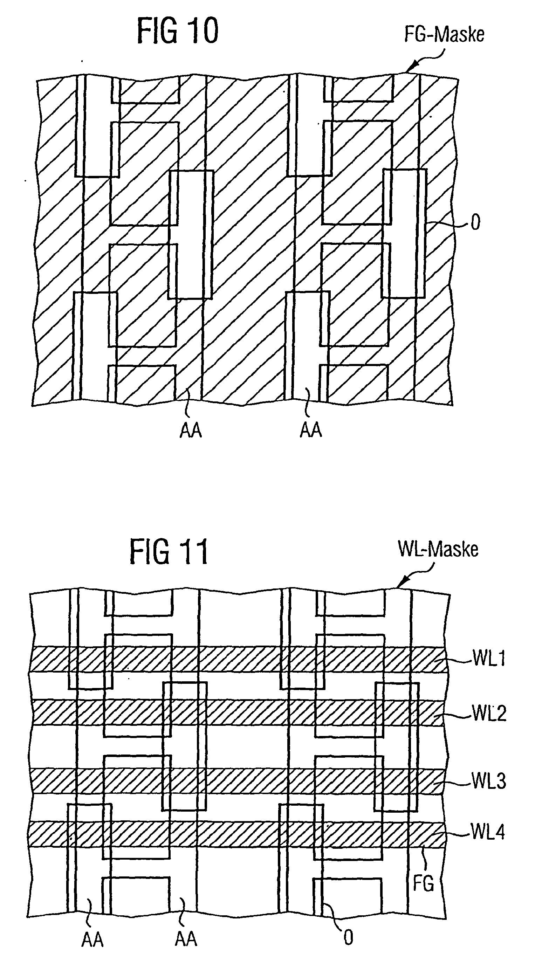

Nachfolgend wird ein Verfahren zur Herstellung der vorstehend beschriebenen NOR-Hableiterspeichereinrichtung mit zwei Eintransistor-Halbleiterspeicherzellen sowie der zugehörigen NOR-Halbleiterspeichervorrichtung anhand von wesentlichen Verfahrensschritten beschrieben. Gemäß Figur 10 und Figur 5 werden zunächst in einem Halbleitersubstrat ringförmige aktive Bereiche AA ausgebildet, die vorzugsweise in x-Richtung aneinander grenzen und elektrisch miteinander verbunden sind. Anschließend wird in einem weiteren Verfahrensschritt eine erste Isolationsschicht I1 ausgebildet, die als Tunneloxidschicht verwendet wird und vorzugsweise aus einem thermisch ausgebildeten Siliziumdioxid besteht. Nach dem Ausbilden der ersten Isolationsschicht I1 wird eine ladungsspeichernde Schicht FG beispielsweise als elektrisch leitende Polysiliziumschicht ganzflächig auf dem Halbleitersubstrat 1 abgeschieden und in einem nachfolgenden Schritt Implantationsöffnungen O derart in der ladungsspeichernden Schicht FG ausgebildet, dass sie an vorbestimmten Bereichen des aktiven Bereichs AA liegen, an denen später die nicht linearen Widerstände NW1, NW2, ... ausgebildet werden. Die entsprechende FG-Maske ist in Figur 10 im Einzelnen dargestellt.

Unter Verwendung dieser in Figur 10 dargestellten FG-Maske wird eine Implantation von Ladungsträgern zum Ausbilden eines flachen Implantationsgebietes FI in den vorbestimmten Bereichen des aktiven Bereiches AA durchgeführt. Auf diese Weise werden vorbestimmte Bereiche des ringförmigen aktiven Bereichs AA elektrisch leitend. In einem weiteren Verfahrensschritt wird anschließend eine zweite Isolationsschicht 12 an der Oberfläche der ladungsspeichernden Schicht FG und des Halbleitersubstrats 1 ausgebildet, die im Wesentlichen als Isolationsschicht zwischen nachfolgend ausgebildeten Wortleitungen WL1, ... und der ladungsspeichernden Schicht FG dient. In einem nachfolgenden Schritt wird eine erste leitende Schicht (z.B. Polysilizium) ganzflächig an der Oberfläche der zweiten Isolationsschicht 12 zur Realisierung der Wortleitungen WL1, WL2, ... ausgebildet und mit einer in Figur 11 dargestellte Wortleitungsmaske WL-Maske bedeckt. In einem nachfolgenden Schritt werden Abschnitte der ersten leitenden Schicht CG, der zweiten Isolationsschicht I2 und der ladungsspeichernden Schicht FG unter Verwendung der streifenförmigen WL-Maske entfernt, sog. Sandwich-Ätzung, wodurch die jeweiligen streifenförmigen Wortleitungen WL1, WL2, ... und darunter liegende (voneinander getrennte) ladungsspeichernde Schichten FG1, ... ausgebildet werden. In Richtung der Wortleitungen WL1, WL2,..., werden diese ladungsspeichernden Schichten durch die Implantationsöffnungen O getrennt. Anschließend erfolgt ein selbstjustierendes Ausbilden von Drain- und Sourcegebieten D und S in den aktiven Bereichen AA unter Verwendung der streifenförmigen ersten leitenden Schicht bzw. der Wortleitungen WL1, WL2, ... (WL-Maske). In einem weiteren nicht dargestellten Schritt werden Kontakte K in dem aktiven Bereich AA ausgebildet und zur Realisierung von Source- und Drainleitungen SL1, ... und DL1, ... darüber liegende streifenförmige elektrisch leitende Schichten ausgebildet, die im Wesentlichen senkrecht zu den Wortleitungen WL1, WL2, ... laufen und mit den Kontakten K in Verbindung stehen.

Auf diese Weise erhält man einen einfachen und kostengünstigen Prozess zur Herstellung einer sehr platzsparenden NOR-Halbleiterspeichereinrichtung mit zwei Eintransistor-Halbleiterspeicherzellen sowie der dazugehörigen NOR-Halbleiterspeichervorrichtung. Insbesondere aufgrund der selbstjustierenden Ausbildung der nicht linearen Widerstände NW1, ... sowie der ladungsspeichernden Schichten FG1, ... und der Source- und Draingebiete S1/D1, ... ermöglicht ein derartiges Verfahren die Durchführung einer weitergehenden Integration bei relativ geringen Kosten.

Insbesondere bei Durchführung der Implantation zum Ausbilden des flachen Implantationsgebietes FI im nicht linearen Widerstand kann vorzugsweise eine schräge Implantation zum Ausbilden von ausreichenden Dotierungen in den Randgebieten durchgeführt werden, was insbesondere bei einer durch die vorstehend beschriebene Sandwich-Ätzung im Offnungsbereich O verursachten geringfügigen Unterätzung des Halbleitersubstrats 1 im aktiven Bereich AA von Bedeutung ist. Eine zuverlässige leitende Verbindung ist somit jederzeit sichergestellt.

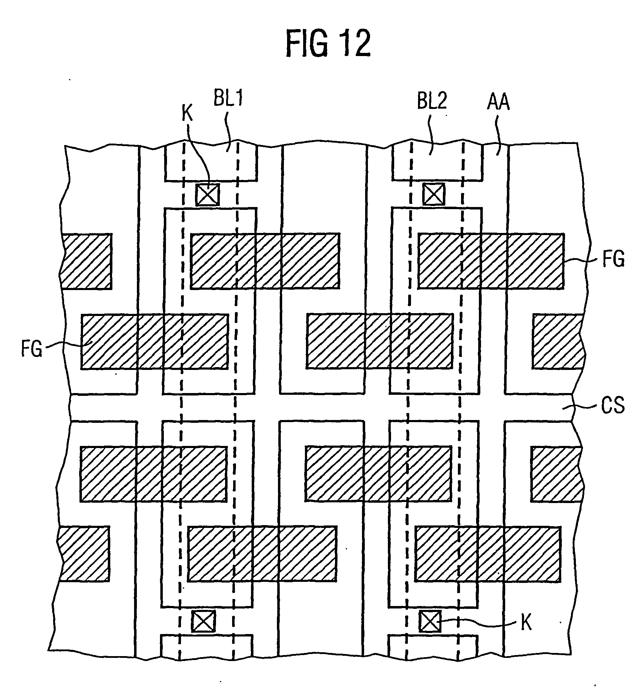

Figur 12 zeigt eine vereinfachte Darstellung eines Layouts der erfindungsgemäßen NOR-Halbleiterspeichervorrichtung gemäß einem dritten Ausführungsbeispiel, wobei gleiche Bezugszeichen gleiche oder ähnliche Schichten bzw. Elemente bezeichnen wie in Figuren 4 bis 11 und auf eine detaillierte Beschreibung nachfolgend verzichtet wird. Zur klareren Darstellung wurde hierbei bewusst auf die Darstellung der Wortleitungen verzichtet.

Gemäß Figur 12 ist eine NOR-Halbleiterspeichervorrichtung mit sogenannter "common-source"-Architektur dargestellt, wobei jeweilige Sourcegebiete über einen gemeinsamen Sourceanschluss CS (common source) angeschaltet sind. Die ringförmigen aktiven Bereich (AA) stehen hierbei auch spaltenweise in Verbindung, wodurch sich eine wesentliche Vereinfachung bei der Metallisierung und Verringerung der Anzahl von Kontakten K ergibt. Jede Halbleiterspeichereinrichtung mit zwei Eintransistor-Halbleiterspeicherzellen besitzt gemäß Figur 12 lediglich jeweils einen Kontakt K für die Bitleitungen BL1, BL2, ... bzw. zum Anschließen der jeweiligen Draingebiete.

Die vorliegende Erfindung wurde anhand einer rechteckigen ringförmigen Struktur der aktiven Bereiche beschrieben. Sie ist jedoch nicht darauf beschränkt und umfasst vielmehr auch quadratische, mehreckige oder sonstige Strukturen, die im Wesentlichen ringförmig sind.

## Patentansprüche

1. Nichtflüchtige NOR-Halbleiterspeichereinrichtung mit zwei Eintransistor-Halbleiterspeicherzellen mit
einem in einem Halbleitersubstrat (1) ausgebildeten aktiven Bereich (AA);
einer ersten Wortleitung (WL1) zum Ansteuern eines ersten Speichertransistors (T1);
einer zweiten Wortleitung (WL2) zum Ansteuern eines zweiten Speichertransistors (T2);
einer Sourceleitung (SL1) zum Anschließen von Sourcegebieten (S1, S2) der Speichertransistoren (T1, T2); und
einer Drainleitung (DL1) zum Anschließen von Draingebieten (D1, D2) der Speichertransistoren,
**dadurch gekennzeichnet, dass** der aktive Bereich (AA) im Wesentlichen ringförmig ausgebildet ist und die beiden Speichertransistoren (T1, T2) mit ihren Drain-, Kanal- und Sourcegebieten in sich gegenüberliegenden Segmenten des ringförmig ausgebildeten aktiven Bereiches (AA) ausgebildet sind, wobei die Draingebiete (D1, D2) und die Sourcegebiete (S1, S2) der beiden Speichertransistoren (T1, T2) jeweils über den ringförmig ausgebildeten aktiven Bereich (AA) miteinander verbunden sind.

2. Nichtflüchtige NOR-Halbleiterspeichereinrichtung nach Patentanspruch 1,
**dadurch gekennzeichnet, dass**
nur in einem Überlappungsbereich der ersten und zweiten Wortleitungen (WL1, WL2) mit dem aktiven Bereich (AA), bei dem eine ladungsspeichernde Schicht (FG) zum Speichern von Ladungen vorliegt, der erste und zweite Speichertransistor (T1, T2) ausgebildet ist, und weitere Überlappungsbereiche der ersten und zweiten Wortleitung (WL1, WL2) mit dem aktiven Bereich (AA) nicht lineare Widerstände (NW1, NW2) darstellen.

3. NOR-Halbleiterspeichervorrichtung mit einer Vielzahl von matrixförmig angeordneten nichtflüchtigen NOR-Halbleiterspeichereinrichtungen mit zwei Eintransistor-Halbleiterspeicherzellen nach Patentanspruch 1 oder 2,
**dadurch gekennzeichnet, dass** die im Wesentlichen ringförmig ausgebildeten aktiven Bereiche (AA) spaltenförmig angeordnet sind.

4. NOR-Halbleiterspeichervorrichtung nach Patentanspruch 3,
**dadurch gekennzeichnet, dass** die Source- und Drainleitungen (SL1, DL1) selektiv angesteuert werden.

5. NOR-Halbleiterspeichervorrichtung nach Patentanspruch 3,
**dadurch gekennzeichnet, dass** die Sourceleitungen (SL1, SL2) gemeinsam miteinander verbunden sind und nur die Drainleitungen (DL1, DL2) selektiv angesteuert werden.

6. NOR-Halbleiterspeichervorrichtung nach einem der Patentansprüche 3 bis 5,
**dadurch gekennzeichnet, dass** die jeweiligen Source- und Drainleitungen (SL1, SL2, DL1, DL2) streifen-, mäander-, zickzack- oder wellenförmig ausgebildet sind.

7. NOR-Halbleiterspeichervorrichtung nach einem der Patentansprüche 3 bis 6,
**dadurch gekennzeichnet, dass** die jeweiligen Source- und Drainleitungen (SL1, SL2, DL1, DL2) in einer gemeinsamen elektrisch leitenden Schicht ausgebildet sind.

8. NOR-Halbleiterspeichervorrichtung nach einem der Patentansprüche 3 bis 6,
**dadurch gekennzeichnet, dass** die jeweiligen Source- und Drainleitungen (SL1, SL2, DL1, DL2) in unterschiedlichen elektrisch leitenden Schichten ausgebildet sind.

9. NOR-Halbleiterspeichervorrichtung nach einem der Patentansprüche 3 bis 8,
**dadurch gekennzeichnet, dass** die jeweiligen Source- und Drainleitungen (SL1, SL2, DL1, DL2) im Wesentlichen parallel zueinander und/oder überlappend angeordnet sind.

10. Verfahren zum Herstellen einer nichtflüchtigen NOR-Halbleiterspeichereinrichtung mit zwei Eintransistor-Halbleiterspeicherzellen mit den Schritten:
a) Ausbilden von ringförmigen aktiven Bereichen (AA) in einem Halbleitersubstrat (1);
b) Ausbilden einer ersten Isolationsschicht (I1) an der Oberfläche des Halbleitersubstrats (1);
c) Ausbilden einer ladungsspeichernden Schicht (FG) an der Oberfläche der ersten Isolationsschicht (I1);
d) Ausbilden von Implantationsöffnungen (O) in der ladungsspeichernden Schicht (FG) an vorbestimmten Bereichen des aktiven Bereichs (AA);
e) Durchführen einer Implantation zum Ausbilden eines flachen Implantationsgebietes (FI) in den vorbestimmten Bereichen des aktiven Bereichs (AA);
f) Ausbilden einer zweiten Isolationsschicht (I2) an der Oberfläche der ladungsspeichernden Schicht (FG) und des Halbleitersubstrats (1);
g) Ausbilden von streifenförmigen ersten leitenden Schichten (CG) an der Oberfläche der zweiten Isolationsschicht (I2);
h) Entfernen der zweiten Isolationsschicht (I2) und der ladungsspeichernden Schicht (FG) unter Verwendung der streifenförmigen ersten leitenden Schicht (CG) als Maske;
i) Selbstjustierendes Ausbilden von Drain- und Sourcegebieten (D1, D2, S1, S2) für zwei Speichertransistoren (T1, T2) im aktiven Bereich (AA) unter Verwendung der streifenförmigen ersten leitenden Schicht (CG) als Maske, wobei die Drain- und Sourcegebiete in sich gegenüberliegenden Segmenten des ringförmig ausgebildeten aktiven Bereiches (AA) ausgebildet und jeweils über die vorbestimmten Bereiche des ringförmig ausgebildeten aktiven Bereichs (AA) miteinander verbunden sind;
j) Ausbilden von Kontakten (K) im aktiven Bereich (AA); und
k) Ausbilden einer streifenförmigen zweiten leitenden Schicht (DL1, SL1) zur Realisierung von Source- und Drainleitungen.

11. Verfahren nach Patentanspruch 10,
**dadurch gekennzeichnet, dass** in Schritt e) eine schräge Implantation zum Ausbilden einer ausreichenden Dotierung in den Randgebieten des flachen Implantationsgebietes (FI) durchgeführt wird.

## Claims

1. Nonvolatile NOR semiconductor memory device having two one-transistor semiconductor memory cells having
an active region (AA) formed in a semiconductor substrate (1);
a first word line (WL1) for the driving of a first memory transistor (T1)
a second word line (WL2) for the driving of a second memory transistor (T2);
a source line (SL1) for the connection of source regions (S1, S2) of the memory transistors (T1, T2); and
a drain line (DL1) for the connection of drain regions (D1, D2) of the memory transistors,
**characterized in that** the active region (AA) is formed essentially in annular fashion and the two memory transistors (T1, T2) are formed with their drain, channel and source regions in mutually opposite segments of the active region (AA) formed in annular fashion, the drain regions (D1, D2) and the source regions (S1, S2) of the two memory transistors (T1, T2) in each case being connected to one another via the active region (AA) formed in annular fashion.

2. Nonvolatile NOR semiconductor memory device according to Patent Claim 1,
**characterized in that**
the first and second memory transistors (T1, T2) are formed only in an overlap region of the first and second word lines (WL1, WL2) with the active region (AA) in which a charge-storing layer (FG) for storing charges is present, and
further overlap regions of the first and second word lines (WL1, WL2) with the active region (AA) constitute nonlinear resistors (NW1, NW2).

3. NOR semiconductor memory apparatus having a multiplicity of nonvolatile NOR semiconductor memory devices arranged in matrix form and having two one-transistor semiconductor memory cells according to Patent Claim 1 or 2,
**characterized in that** the active regions (AA) formed essentially in annular fashion are arranged in column form.

4. NOR semiconductor memory apparatus according to Patent Claim 3,
**characterized in that** the source and drain lines (SL1, DL1) are driven selectively.

5. NOR semiconductor memory apparatus according to Patent Claim 3,
**characterized in that** the source lines (SL1, SL2) are jointly connected to one another and only the drain lines (DL1, DL2) are driven selectively.

6. NOR semiconductor memory apparatus according to one of Patent Claims 3 to 5,
**characterized in that** the respective source and drain lines (SL1, SL2, DL1, DL2) are formed in strip, meandering, zigzag or undulating form.

7. NOR semiconductor memory apparatus according to one of Patent Claims 3 to 6,
**characterized in that** the respective source and drain lines (SL1, SL2, DL1, DL2) are formed in a common electrically conductive layer.

8. NOR semiconductor memory apparatus according to one of patent claims 3 to 6,
**characterized in that** the respective source and drain lines (SL1, SL2, DL1, DL2) are formed in different electrically conductive layers.

9. NOR semiconductor memory apparatus according to one of Patent Claims 3 to 8,
**characterized in that** the respective source and drain lines (SL1, SL2, DL1, DL2) are arranged essentially parallel to one another and/or in overlapping fashion.

10. Method for fabricating a nonvolatile NOR semiconductor memory device having two one-transistor semiconductor memory cells, having the following steps:
a) formation of annular active regions (AA) in a semiconductor substrate (1);
b) formation of a first insulation layer (I1) at the surface of the semiconductor substrate (1);
c) formation of a charge-storing layer (FG) at the surface of the first insulation layer (I1);
d) formation of implantation openings (O) in the charge-storing layer (FG) at predetermined regions of the active region (AA);
e) performance of an implantation in order to form a shallow implantation region (FI) in the predetermined regions of the active region (AA);
f) formation of a second insulation layer (I2) at the surface of the charge-storing layer (FG) and the semiconductor substrate (1);
g) formation of strip-type first conductive layers (CG) at the surface of the second insulation layer (I2);
h) removal of the second insulation layer (I2) and the charge-storing layer (FG) using the strip-type first conductive layer (CG) as mask;
i) self-aligning formation of drain and source regions (D1, D2, S1, S2) for two memory transistors (T1, T2) in the active region (AA) using the strip-type first conductive layer (CG) as mask, the drain and source regions being formed in mutually opposite segments of the active region (AA) formed in annular fashion and in each case being connected to one another via the predetermined regions of the active region (AA) formed in annular fashion;
j) formation of contacts (K) in the active region (AA); and
k) formation of a strip-type second conductive layer (DL1, SL1) for the realization of source and drain lines.

11. Method according to Patent Claim 10,
**characterized in that**, in step e), an inclined implantation is performed in order to form an adequate doping in the edge regions of the shallow implantation region (FI) .

## Revendications

1. Dispositif de mémoire à semi-conducteur NON-OU non volatil, ayant deux cellules de mémoire à semi-conducteur à un transistor, comprenant
une zone (AA) active constituée dans un substrat (1) semi-conducteur ;
une première ligne (WL1) de mots pour commander un premier transistor (T1) de mémoire ;
une deuxième ligne (WL2) de mots pour commander un deuxième transistor (T2) de mémoire ;
une ligne (SL1) de source pour le raccordement de régions (S1, S2) de source des transistors (T1, T2) de mémoire ; et
une ligne (DL1) de drain pour le raccordement de régions (D1, D2) de drain des transistors de mémoire,
**caractérisé en ce que** la zone (AA) active est constituée de façon sensiblement annulaire et les deux transistors (T1, T2) de mémoire sont constitués en ayant leurs régions de drain, de canal et de source dans des segments opposés de la zone (AA) active constituée de manière annulaire, les régions (D1, D2) de drain et les régions (S1, S2) de source des deux transistors (T1, T2) de mémoire étant reliées entre elles, respectivement, par la zone (AA) active constituée de manière annulaire.

2. Dispositif de mémoire à semi-conducteur NON-OU non volatil suivant la revendication 1,
**caractérisé en ce que** le premier et le deuxième transistors (T1, T2) ne sont constitués que dans une zone de chevauchement des première et deuxième lignes (WL1, WL2) de mots avec la zone (AA) active dans laquelle il y a une couche (FG) d'accumulation de charge pour accumuler des charges, et
d'autres zones de chevauchement des première et deuxième lignes (WL1, WL2) de mots avec la zone (AA) active constituent des résistances (NW1, NW2) non linéaires.

3. Système de mémoire à semi-conducteur NON-OU ayant une pluralité de dispositifs de mémoire à semi-conducteur NON-OU non volatils disposés sous la forme d'une matrice et ayant deux cellules de mémoire à semi-conducteur à un transistor suivant la revendication 1 ou 2,
**caractérisé en ce que** les zones (AA) actives constituées sensiblement de manière annulaire sont disposées sous forme de colonnes.

4. Système de mémoire à semi-conducteur NON-OU suivant la revendication 3,
**caractérisé en ce que** les lignes (SL1, DL1) de source et de drain sont commandées sélectivement.

5. Système de mémoire à semi-conducteur NON-OU suivant la revendication 3,
**caractérisé en ce que** les lignes (SL1, SL2) de source sont reliées mutuellement ensemble et seules les lignes (DL1, DL2) de drain sont commandées sélectivement.

6. Système de mémoire à semi-conducteur NON-OU suivant l'une des revendications 3 à 5,
**caractérisé en ce que** les lignes (SL1, SL2, DL1, DL2) de source et de drain respectives sont constituées sous forme de bandes, sous forme sinueuse, en zigzag ou sous forme ondulée.

7. Système de mémoire à semi-conducteur NON-OU suivant l'une des revendications 3 à 6,
**caractérisé en ce que** les lignes (SL1, SL2, DL1, DL2) respectives de source et de drain sont constituées dans une couche commune conductrice de l'électricité.

8. Système de mémoire à semi-conducteur NON-OU suivant l'une des revendications 3 à 6,
**caractérisé en ce que** les lignes (SL1, SL2, DL1, DL2) respectives de source et de drain sont constituées dans des couches conductrices de l'électricité différentes.

9. Système de mémoire à semi-conducteur NON-OU suivant l'une des revendications 3 à 8,
**caractérisé en ce que** les lignes (SL1, SL2, DL1, DL2) respectives de source et de drain sont sensiblement parallèles entre elles et/ou se chevauchent.

10. Procédé de fabrication d'un système de mémoire à semi-conducteur NON-OU non volatil ayant deux cellules de mémoire à semi-conducteur à un transistor comprenant les stades dans lesquels :
a) on forme des zones (AA) actives annulaires dans un substrat (1) semi-conducteur ;
b) on forme une première couche (I1) isolante à la surface du substrat (1) semi-conducteur ;
c) on forme une couche (FG) d'accumulation de charge à la surface de la première couche (I1) isolante ;
d) on forme des ouvertures (0) d'implantation dans la couche (FG) d'accumulation de charge en des zones déterminées à l'avance de la zone (AA) active ;
e) on effectue une implantation pour former une région (FI) d'implantation plate dans les zones déterminées à l'avance de la zone (AA) active ;
f) on forme une deuxième couche (I2) isolante à la surface de la couche (FG) d'accumulation de charge et du substrat (1) semi-conducteur ;
g) on forme des premières couches (CG) conductrices en forme de bandes à la surface de la deuxième couche (I2) isolante ;
h) on élimine la deuxième couche (I2) isolante et la couche (FG) d'accumulation de charge en utilisant la première couche (CG) conductrice en forme de bande comme masque ;
i) on forme, avec auto-alignement, des régions (D1, D2, S1, S2) de drain et de source pour deux transistors (T1, T2) de mémoire dans la zone (AA) active, en utilisant la première couche (CG) conductrice en forme de bande comme masque, les régions de drain et de source étant formées dans des segments opposés de la zone (AA) active constituée de façon annulaire et étant reliées entre elles, respectivement, par les zones déterminées à l'avance de la zone (AA) active constituée de manière annulaire ;
j) on forme des contacts (K) dans la zone (AA) active ; et
k) on forme une deuxième couche (DL1, SL1) conductrice en forme de bande pour réaliser des lignes de source et de drain.

11. Procédé suivant la revendication 10,
**caractérisé en ce qu'**au stade e), on effectue une implantation inclinée pour constituer un dopage suffisant dans les régions marginales de la région (FI) d'implantation plate.
